# EUROPEAN PATENT APPLICATION

(11) **EP 4 502 650 A1**
(43) Date of publication of application: **05.02.2025**
(21) Application number: 23189425.4
(22) Date of filing: 03.08.2023
(51) Int. Cl.: G01S 7/481, G01S 7/4911, G01S 7/4912, G01S 17/36, H01S 3/10, H01S 5/10, H01S 5/14

(54) **TUNABLE LIGHT SOURCE FOR FMCW LIDAR DEVICES**

(71) Applicant: Scantinel Photonics GmbH, 89077 Ulm (DE)
(72) Inventor: AKSARIN, Stanislav, 76187 Karlsruhe (DE)
(74) Representative: Ostertag & Partner Patentanwälte mbB

(57) **Abstract**

A tunable light source (16) for an FMCW LiDAR device comprises an external cavity laser (35) including a laser gain medium (36) having a light output facet (37) emitting laser light, a reflector (46) and an external cavity waveguide (44) extending between the light output facet (37) and the reflector (46). A variable phase shifter (60) is arranged in the external cavity waveguide (44). An optical splitter (40, 68) splits off a portion of the laser light and has an output port (69). An optical phase-locked loop (70) is optically coupled to the optical splitter and electrically coupled to the laser gain medium (36). The optical phase-locked loop comprises a first arm (88) and a second arm (90), wherein the first arm (88) and the second arm (90) have different optical path lengths, a double stage single-sideband Weaver mixer (74) comprising an optical stage (72) and an electrical stage (73), a phase detector (76) and a loop filter (80) that are electrically connected in series.

## Description

### BACKGROUND OF THE INVENTION

### 1. Field of the Invention

The invention relates to a tunable light source for FMCW Lidar devices that are used for range and/or velocity measurements relative to a moving or unmoving object.

### 2. Description of Related Prior Art

Frequency-modulated continuous wave (FMCW) is a range and velocity measuring technology which was originally developed for RADAR applications. If light instead of radio waves are used, this technology is usually referred to as FMCW LiDAR, in which LiDAR is an acronym for "Light Detection And Ranging".

In an FMCW LiDAR device, a frequency-modulated ("chirped") light beam scans the environment. A small fraction of the light is diffusely reflected at the object, received by the device and superimposed with a local oscillator wave. The frequency difference between the two signals, which is usually referred to as beat frequency, is measured and used to compute the range R of the object. It is also possible to compute the radial relative velocity ***ν*** based on the Doppler frequency shift that is observed in the present of a relative velocity.

By using a tunable laser as light source and a photodiode as detector, the beat frequency can be extracted directly from the photodiode current, because the photodiode delivers a current that is proportional to the squared sum of the two optical waves ("self-mixing effect").

The accuracy of the distance and velocity measurement depends, among other, on the spectral linewidth of the light source, the modulation frequency span ***Δf*** and the linearity of the frequency sweep. This places high requirements on the light source.

Conventional DFB or DBR diode lasers having a suitable operating wavelength, which is preferably outside the visible light spectral window, typically have a linewidth of a few MHz. Usually, due to the semiconductor's inherent broad gain spectrum, more than one mode will operate simultaneously, resulting in multiple output wavelengths and a broad linewidth. However, for achieving the accuracy required in autonomous driving and similar applications, a linewidth in the MHz range is too large. What is required is a reduction by about three orders of magnitude, i.e. a linewidth in the kHz range.

EP 4 075 613 A1 A proposes a light source for an FMCW LiDAR device that is formed by a photonic integrated circuit (PIC). A semiconductor laser gain medium is received in a recess that is etched into a multilayer structure of the PIC. An optical path between the gain medium and a reflector forms an external cavity of the semiconductor laser. In an embodiment, the external cavity includes a variable attenuator and a variable optical phase shifter.

Thanks to the external cavity, the linewidth of the light is significantly reduced. However, the external cavity as such does not ensure that the frequency sweep of the laser is sufficiently linear. To this end, optical phased-locked loops have been considered, as this is described, for example, in GB 2 175 437 A and US 8,175,126 B2.

One disadvantage of the prior art optical phased-locked loops is that they require a considerable optical delay if high chirp rates at a large chirp bandwidth shall be achieved. For example, a small phase delay of 30 ns requires a delay line having a length of roughly 6 m for typical optical fibers or waveguides. However, for high chirp rates at a large chirp bandwidth, the phase delay must be much higher than 30 ns. The afore-mentioned US 8,175,126 B2 describes a fiber delay of 20 km resulting in a delay of 100 µs. Such long delay lines can only be realized with optical fibers, and even this is difficult to achieve if the available space in the device is restricted.

Furthermore, the use of optical fibers is not preferred, because one of the main objectives in the design of LiDAR devices is to optically integrate as many as possible optical and electrical elements in a photonic integrated circuit (PIC). Only then the FMCW LiDAR device will be so small, cheap and reliable that it can be used in demanding applications such as autonomous driving.

### SUMMARY OF THE INVENTION

It is therefore an object of the present invention to provide a tunable light source for FMCW LiDAR devices that includes an optical phased-locked loop enabling high and precisely controlled chirp rates at a large chirp bandwidth, but without a need for a long optical delay line so that the phased-locked optical loop can be realized with short optical fibers or no optical fibers at all.

This object is achieved, in accordance with the present invention, by a tunable light source for FMCW LiDAR devices comprising an external cavity laser. The laser comprises a laser gain medium having a light output facet configured to emit laser light, a reflector and an external cavity waveguide extending between the light output facet and the reflector. The device further comprises a variable phase shifter arranged in the external cavity waveguide, an optical splitter arranged in the external cavity waveguide, and an optical phase-locked loop. The latter is optically to the optical splitter and electrically coupled to the laser gain medium. The optical phase-locked loop comprises a first arm and a second arm, wherein the first arm and the second arm have different optical path lengths, a double stage single-sideband Weaver mixer comprising an optical stage and an electrical stage, a phase detector and a loop filter that are electrically connected in series.

The invention is based on the perception that the combination of an external cavity laser, a variable phase shifter in the external cavity and a phased-locked loop that controls the laser enables high and precisely controlled chirp rates at a large chirp bandwidth. The use of the Weaver mixer in the phase-lock loop makes it possible to significantly reduce the length of the optical delay line, thereby obviating the need for optical fibers used as delay lines. The use of a Weaver mixer in an optical phased-lock loop is known in the art as such, see, for example, Mingzhi Lu et al, Highly integrated optical heterodyne phase-locked loop with phase/frequency detection, Opt. Express 20, 9736-9741 (2012).

In an embodiment, the optical stage of the double stage single-sideband Weaver mixer comprises a quadrature optical mixer, which is connected to the first arm and the second arm and is configured to produce in-phase and quadrature shifted radio beat frequencies from optical signals guided in the first arm and the second arm. The two arms and the optical stage of the Weaver mixer thus form a Mach-Zehnder interferometer that is used as discriminator.

The quadrature optical mixer may comprise a simple 2x2 coupler and two photodiodes, for example. Preferably, however, the quadrature optical mixer comprises a quadrature hybrid coupler comprising a first input connected to the first arm, a second input connected to the second arm, and four exits that combine light from the first arm and light from the second arm with different phase delays. Two first photodetectors and two second photodetectors are provided, wherein each photodetector has an electrical output and is connected to one of the exits of the quadrature hybrid coupler. The electrical outputs of the first photodetectors are combined to produce the in-phase radio beat frequency, and the electrical outputs of the second photodetectors are combined to produce the quadrature shifted radio beat frequency.

The electrical stage of the single-sideband Weaver mixer may comprise a local oscillator that is configured to produce a first oscillator signal and a second oscillator signal that is phase shifted relative to the first oscillator signal. A first mixer mixes the first oscillator signal with the in-phase radio beat frequency so that a first lower side band signal is obtained. A second mixer mixes the second oscillator signal with the quadrature-shifted radio beat frequency so that a second lower side band signal shifted in quadrature is obtained.

In an embodiment, the light source comprises a waveform generator and a laser driver connected to the loop filter and the waveform generator. The laser driver is configured to produce a laser injection current that is applied to the laser gain medium. The light source also comprises a phase shifter driver that is connected to the waveform generator and configured to produce a control signal that is applied to the variable phase shifter.

In an embodiment, a further optical splitter is provided that splits off a portion of the laser light forming a signal that is finally emitted by the FMCW LiDAR device. The light source may comprise an optical isolator arranged in a light path downstream of the further optical splitter.

Subject of the invention is also an FMCW LiDAR device for measuring a range to an external object and comprising the tunable light source in accordance with the invention. The LiDAR device further comprises a detector configured to detect a superposition of a portion of the laser light that was reflected at the external object with a portion of the laser light that was not reflected at the external object, and a calculation unit configured to determine the range to the object based on the superposition detected by the detector.

### BRIEF DESCRIPTION OF THE DRAWINGS

Various features and advantages of the present invention may be more readily understood with reference to the following detailed description taken in conjunction with the accompanying drawings in which:
- Figure 1: is a schematic side view of a vehicle approaching an object which is detected by a LiDAR device;
- Figure 2: is a top view of the LiDAR device shown in Figure 1;
- Figure 3: schematically shows the layout of a LiDAR device according to an embodiment of the invention;
- Figure 4: is a graph showing the time dependency of the frequency of a light source included in the LiDAR device;
- Figure 5: schematically shows the layout of the light source included in the LiDAR device;
- Figure 6: schematically shows the layout of the optical phase-locked loop contained in the light source shown in Figure 5; and
- Figure 7: is a more detailed representation of the optical phase-locked loop shown in Figure 6.

### DESCRIPTION OF PREFERRED EMBODIMENTS

### 1. Application scenario

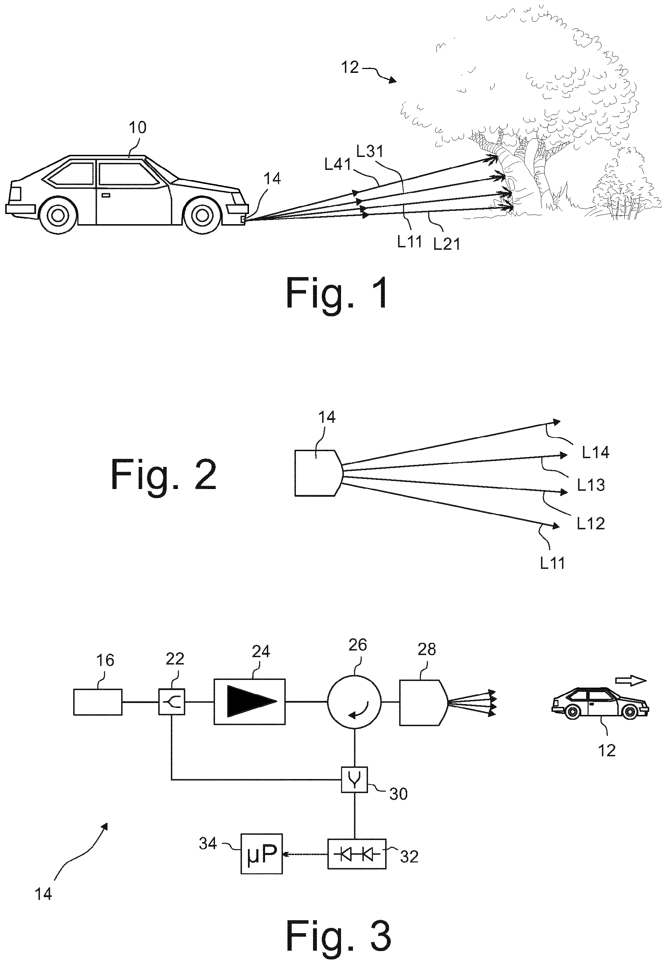

Figure 1 is a schematic side view showing a vehicle 10 that approaches an object 12 represented by a tree. The vehicle 10 has a LiDAR device 14 that scans the environment lying ahead of the vehicle 10 with light beams L11, L21, L31, and L41. From range information associated to each light beam, a three-dimensional image of the environment is computationally reconstructed. In addition, the LiDAR device 14 determines the relative velocity to the object 12 along the direction of the respective light beam L11, L21, L31, and L41. This information is particularly important if the object 12 is not fixed, but moves, too.

The information computed by the LiDAR device 14 about the environment lying ahead of the vehicle 10 may be used, for example, to assist the driver of the vehicle 10 in various ways. For example, warning messages may be generated if a collision of the vehicle 10 with the object 12 threatens. If the vehicle 10 drives autonomously, range and velocity information about the environment lying ahead are required by the algorithms that control the vehicle 10.

As is apparent in Figure 1, the LiDAR device 14 emits the light beams L11 to L41 in different directions in a vertical plane (i.e. the plane of the paper in Figure 1) so that the environment is scanned in the vertical direction. Scanning also takes place simultaneously in the horizontal direction, as Figure 2 illustrates in a top view of the LiDAR device 14. Four light beams L11, L12, L13 and L14 are emitted in a horizontal plane in different directions.

Only for the sake of simplicity it is assumed in Figures 1 and 2 that only four light beams Ln1 to Ln4 are emitted vertically and horizontally. However, in real applications that LiDAR device 14 emits many more light beams. For example, ***k·***2*ⁿ* light beams are preferred, wherein ***n*** is a natural number which is typically between 7 and 13 and specifies how many beams are emitted in one of ***k*** (horizontal or inclined) planes, wherein A is a natural number which is typically between 1 and 16.

### 2. LiDAR device

Figure 3 schematically shows the layout of the LiDAR device 14. The LiDAR device 14 is configured as an FMCW LiDAR system and comprises a light source 16. During operation of the LiDAR device 14, the light source 16 produces light having a frequency ***f_{chirp}*** that periodically varies ("chirps") between a lower frequency ***fₗ*** and a higher frequency ***fₕ*.** The design of the light source will be described in more detail in the next section.

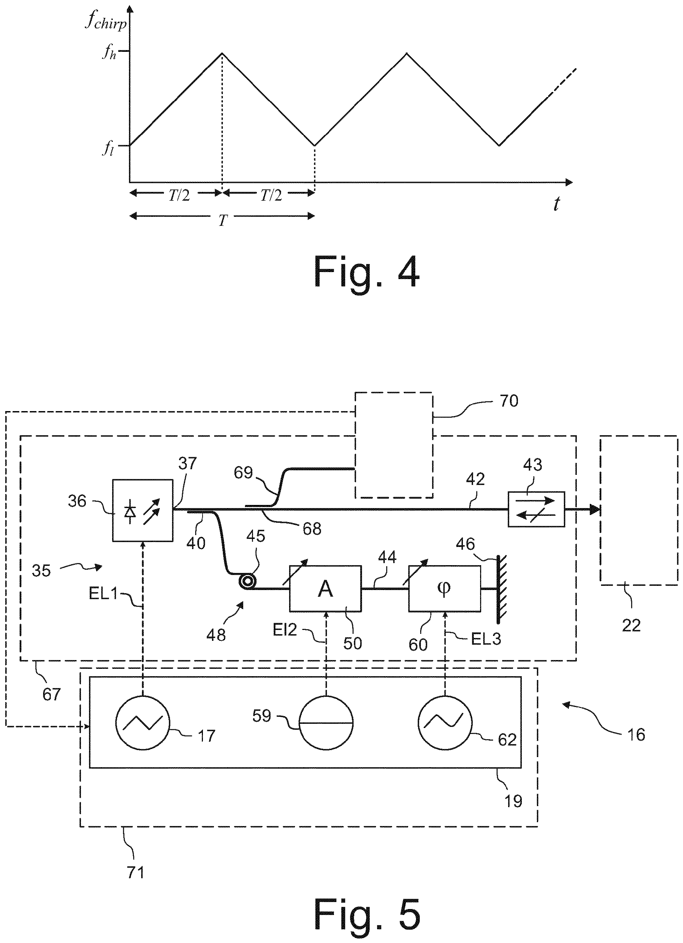

The graph of Figure 4 shows how the frequency ***f_{chirp}*** of the light source 16 varies over time ***t*** in this embodiment. Each measurement interval having a chirp duration ***T*** is divided into two halves of equal length ***T*/*2.*** During the first interval, the frequency ***f_{chirp}*** increases linearly with a constant and positive up-chirp rate ***r_{chirp},*** i.e. d***f_{chirp}***/d***t*** = ***r_{chirp}**.* The first interval is often referred to as up-chirp interval. During the second interval, the frequency ***f_{chirp}*** decreases linearly with a constant negative down-chirp rate *-**r_{chirp}***, i.e. d***f_{chirp}***/d***t*** = *-**r_{chirp}**.* This results in a triangular wave like frequency variation as shown in Figure 4.

The light source 16 is connected to a splitter 22 that splits the measuring light into reference light (sometimes also referred to as "local oscillator") and output light. In this embodiment, the output light passes an optical amplifier 24 and an optical circulator 26 that guides the amplified output light towards a scanning unit 28. An optical circulator has three ports A, B and C and has the property that light entering one port leaves the next port. Therefore, light entering port A leaves port B, light entering port B leaves port C, and light entering port C leaves port A. For example, the optical circulator 26 may comprise a polarization sensitive beam splitter and a Faraday rotator that is arranged in the optical path upstream the scanning unit 28 so as to rotate the state of polarization by 45°, as this is known in the art as such.

This ensures that output light from the amplifier 24 passes the beam splitter without being deviated, while the state of polarization of light reflected from the object 12 will undergo a rotation of 2·45° so that it is deviated by the polarization sensitive beam splitter.

Instead of using an amplifier 24 that amplifies only the output light, it is also possible, for example, to amplify the measuring light before it enters the splitter 22, to use at least one amplifier arranged in at least one light path between the light sources 16, 18 and the optical combiner 20, or to dispense with the amplifier 24 completely.

The scanning unit 28 directs the output light towards the object 12 - in Figure 3 represented by a moving car - along different directions, as it has been explained above with reference to Figures 1 and 2. While some part of each output light beam is usually absorbed by the object 12, another part is reflected. As long as the surface of the object 12 is not perfectly specular, diffuse reflection occurs which ensures that some output light is reflected at the object 12 such that it propagates back towards the scanning unit 28. The reflected output light, which is referred to in the following as input light, is received by the scanning unit 28 and guided towards the optical circulator 26.

The optical circulator 26 directs the input light towards a combiner 30 that combines the reference light, which was separated from the measuring light by the splitter 22, with the input light. A detector 32 arranged behind the further combiner 30 thus detects a superposition of the reference light and the input light. The detector 32 may be configured as a balanced detector, as this is known in the art as such. The electric signals produced by the detector 32 are fed to a computing unit 34 that computes the range R to the object and the relative velocity *ν* between the LiDAR device 14 and the object 12 by analyzing beat frequencies resulting from the superposition detected by the detector 32.

Since no light has to be routed from the combiner 30 towards the splitter 22, using the optical circulator 26 is not mandatory. Often it suffices to use simpler polarization sensitive beam splitting elements instead of the optical circulator 26.

### 3. Light source

Figure 5 schematically shows the most important functional components of the light source 16. The latter comprises a semiconductor laser 35 having a gain medium 36 that is connected, via a first electrical line EL1, to a laser driver unit 17 of an electronic control module 19. The laser driver 17 supplies the gain medium 36 with a varying injection current so that the semiconductor laser 35 produces laser light having a frequency ***f_{chirp}*** that varies synchronously with the varying injection current. It is often preferred that the injection current, and hence the frequency ***f_{chirp}*** of the laser light, varies as shown in Figure 4.

The gain medium 36 has a light output facet 37 that abuts on an external cavity waveguide 44. Light produced by the gain medium 36 couples into the external cavity waveguide 44 and is guided to an optical splitter 40 that splits off a large portion of the laser light to an output optical waveguide 42. The optical splitter 40 has an asymmetric splitting ratio so that most of the light is guided to the output optical waveguide 42. The fraction of the laser light remaining in the external cavity waveguide 44 may be as small as 10⁻³ to 10⁻⁷, and more preferably between 10⁻⁴ to 10⁻⁵. It is noted that in this respect it does not matter whether the external cavity waveguide 44 is a continuous optical waveguide or, as indicated in Figure 5, an optical waveguide that is interrupted by the optical splitter 40.

In the embodiment shown, the output optical waveguide 42 is connected, via an optical isolator 43, to the splitter 22 shown in Figure 3. The optical isolator 43 protects the laser gain medium 36 from unavoidable internal and external reflections. The output optical waveguide 42 thus connects the light source 16 to a light input of the remaining portion of the LiDAR device 14.

The external cavity waveguide 44 may have a geometrical length of a several millimeters to a few centimeters. In order to reduce the overall dimensions of the light source 16, a portion of the external cavity waveguide 44 may be formed as a waveguide spiral indicated at 45.

The external cavity waveguide 44 terminates at a reflector 46. The portion of the light produced by the gain medium 36 and coupled into the external cavity waveguide 44 returns, after being reflected at the reflector 46, on the same way towards the gain medium 36 and enters its internal cavity. The optical path between the output facet of the gain medium 36 and the reflector 46 thus forms an external cavity 48 of the semiconductor laser 35.

The external cavity 48 includes a variable attenuator 50 that causes an attenuation of the light guided in the external cavity waveguide 44. The attenuator 50 may comprise a Mach-Zehnder interferometer (MZI) that is connected, via a second electrical line EL2, to an attenuator driver 59 of the electrical control module 19, as this is described in EP 4 075 613 A1 A that has been mentioned at the outset.

The external cavity 48 further comprises a variable phase shifter 60 acting on the external cavity waveguide 44. The variable phase shifter 60 changes the phase of the light at a change rate that is synchronized with the frequency change of the light. In the embodiment shown, the variable phase shifter 60 is thermally tunable. A third electrical line EL3 connects a waveguide heater of the variable phase shifter 60 to a phaser shifter driver 62 of the electrical control module 19. In this manner, the waveguide heater can be supplied with a varying heating current.

In the embodiment shown, the optical components of the light source 16 are implemented as a Si-SiN based photonic integrated circuit (PIC) on which the laser gain medium 36 and the optical isolator 43 are bonded so that a hybrid PIC component 67 is obtained. The electrical control module 19 with the laser driver 17, the attenuator driver 59 and the phase shifter driver 62 are commonly arranged on an electronic integrated circuit 71.

The light source 16 comprises a further optical splitter 68 that splits off a small fraction of the laser light. An output port 69 of the further optical splitter 68 is connected to an optical phase-locked loop 70. In the embodiment shown, the further optical splitter 68 is arranged in the output optical waveguide 42. However, it is also possible to arrange the further optical splitter 68 in the external cavity waveguide 44. It only matters that a small fraction of the laser light is guided to the optical phase-locked loop 70 that will be explained in more detail in the following section.

### 4. Optical phase-locked loop

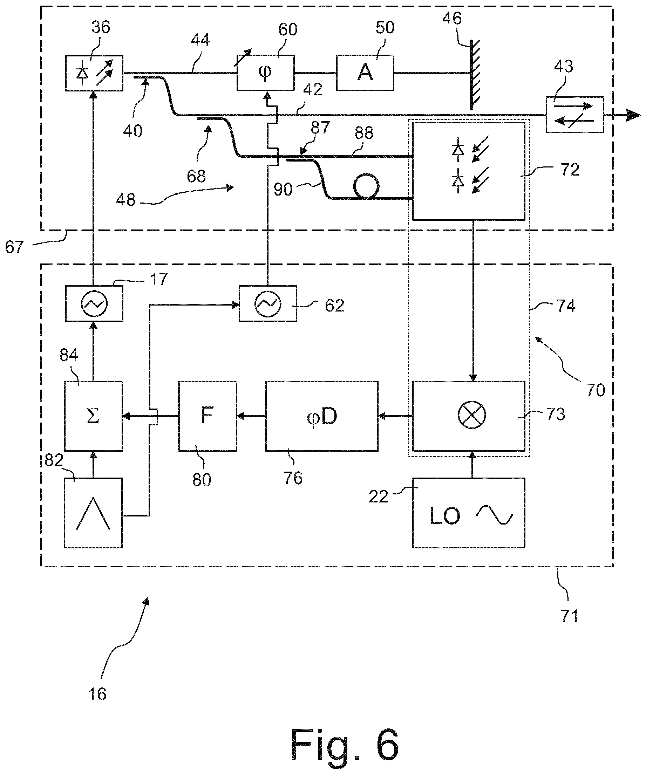

Figure 6 schematically shows the layout of the optical phase-locked loop 70 as comprising a splitter 87 that splits said small fraction of the laser light between a first arm 88 and a second arm 90, wherein the first arm 88 and the second arm 90 have different optical path lengths. The phase-locked loop 70 further comprises a double stage single-sideband Weaver mixer 74 comprising an optical stage 72 and an electrical stage 73, a phase detector 76 and a loop filter 80 that are electrically connected in series. The optical phase-locked loop 70 generates an electrical feedback signal that is used for correction of the injection current that is supplied to the laser gain medium 36.

The electrical stage 73 of the Weaver mixer receives two phase shifted local oscillator signals with target frequency f_{b0} that are produced by a local oscillator 75.

The optical phase-locked loop 70 further comprises a waveform generator 82 that produces an electrical target waveform, e.g. the waveform shown in Fig. 4. To this target waveform the output signal of the loop filter 80 is added in an adding unit 84 as a correction signal. The corrected waveform signal is supplied to the laser driver 17 producing a laser injection current that is applied to the laser gain medium 36.

The variable phase shifter driver 62 directly receives the target waveform from the waveform generator 82. This enables a large chirp range ***Δf* = *fₕ - fₗ.***

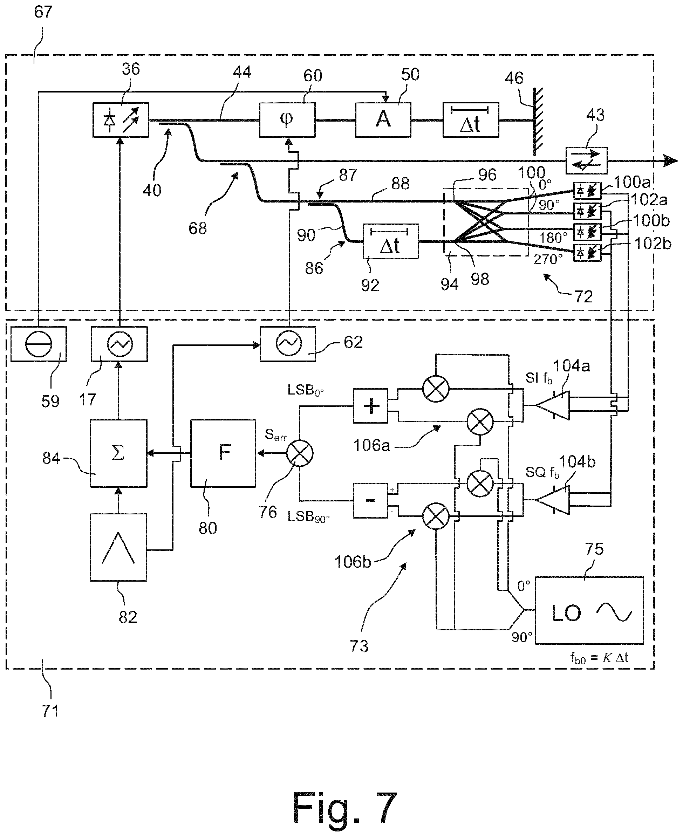

Figure 7 is a more detailed representation of the optical phase-locked loop 70 shown in Figure 6. The second arm 90 contains an optical delay line 92 which may be realized as an on-chip waveguided spiral. The delay **Δ*t*** produced by the delay line 92 is typically in a range between 0,5 to 2 ns. The two arms 88, 90 thus have different optical path lengths. The optical stage 72 of the Weaver mixer 74 comprises a quadrature hybrid coupler 94 that mixes the optical signals guided in the two arms 88, 90 with different phase delays.

More specifically, the quadrature hybrid coupler 94, which may be formed by a 2 x 4 star coupler, has a first input 96 connected to the first arm 88, a second input 98 connected to the second arm 90, and four exits 100 that combine light from the first arm 88 and light from the second arm 90 with phase delays of 0°, 90°, 180° and 270°. The optical stage 72 of the Weaver mixer further comprises two first photodetectors 100a, 100b and two second photodetectors 102a, 102b each having an electrical output and being connected to one of the exits 100 of the quadrature hybrid coupler 94. The output currents of the first photodetectors 100a, 100b are combined and converted by a first transimpedance amplifier 104a into a voltage that correspond to the in-phase (SI) radio beat frequency. Similarly, the output currents of the second photodetectors 102a, 102b are combined and converted by a second transimpedance amplifier 104b into a voltage that correspond to the quadrature shifted (SQ) radio beat frequency. The arms 88, 90 and the optical stage 72 of the Weaver mixer commonly form a Mach-Zehnder interferometer.

The Sl and SQ beat signals denoted in Figure 7 by Sl f_{b} and SQ f_{b} are then mixed in the electrical stage 73 of the single-sideband Weaver mixer 74 with two quadrature shifted local oscillator signals provided by the local oscillator 75 and having a varying frequency f_{b0} = ***K ·* Δt**, with ***K*** being the chirp rate. A first mixer 106a mixes the first oscillator signal with the in-phase radio beat frequency Sl f_{b} provided by the first transimpedance amplifier 104a so that a first lower side band signal LSB_{0°} is obtained. A second mixer 106b mixes the second quadrature shifted oscillator signal with the quadrature-shifted radio beat frequency SQ f_{b} so that a second lower side band signal LSB_{90°} shifted in quadrature is obtained.

The phase detector 76 mixes the two lower side band signals LSB_{0°} and LSB_{90°} and produces an error signal Sₑᵣᵣ that is fed to the loop filter 80. This error signal Sₑᵣᵣ represents the deviation of the detected beat frequency f_{b} from the target beat frequency f_{b0} produced by the local oscillator 75. The loop filter 80 is specifically designed to compensate the common delay in the loop and enables a quick response of the laser injection current to the deviation of the beat frequency signal from the local oscillator signal.

In a simplified version, the loop filter 80 is formed by a lag compensator. The limiting factor in that case is the PI (proportional integral) controller.

## Claims

1. A tunable light source for FMCW LiDAR devices, comprising
an external cavity laser (35) that comprises
a laser gain medium (36) having a light output facet (37) configured to emit laser light,
a reflector (46) and
an external cavity waveguide (44) extending between the light output facet (37) and the reflector (46);
a variable phase shifter (60) arranged in the external cavity waveguide (44);
an optical splitter (40, 68) configured to split off a portion of the laser light; and
an optical phase-locked loop (70) that is optically coupled to the optical splitter and electrically coupled to the laser gain medium (36), wherein the optical phase-locked loop comprises a first arm (88), a second arm (90), wherein the first arm (88) and the second arm (90) have different optical path lengths, a double stage single-sideband Weaver mixer (74) comprising an optical stage (72) and an electrical stage (73), a phase detector (76) and a loop filter (80) that are electrically connected in series.

2. The light source of claim 1, wherein the optical stage (72) of the double stage single-sideband Weaver mixer (74) comprises a quadrature optical mixer (94), which is connected to the first arm (88) and the second arm (90) and is configured to produce in-phase and quadrature shifted radio beat frequencies from optical signals guided in the first arm (88) and the second arm (90).

3. The light source of claim 2, wherein the quadrature optical mixer comprises
a quadrature hybrid coupler (94) comprising
a first input (96) connected to the first arm (88),
a second input (98) connected to the second arm (90), and
four exits (100) that combine light from the first arm (88) and light from the second arm (90) with different phase delays; and
two first photodetectors (100a, 100b) and two second photodetectors (102a, 102b), wherein
each photodetector (100a, 100b, 102a, 102b) has an electrical output and is connected to one of the exits (100) of the quadrature hybrid coupler,
the electrical outputs of the first photodetectors (100a, 100b) are combined to produce the in-phase radio beat frequency, and wherein
the electrical outputs of the second photodetectors (102a, 102b) are combined to produce the quadrature shifted radio beat frequency.

4. The light source of any of claims 1 to 3, wherein the electrical stage of the double stage single-sideband Weaver mixer (74)
comprises a local oscillator (75) that is configured to produce a first oscillator signal and a second oscillator signal that is phase shifted relative to the first oscillator signal,
a first mixer (106a) that is configured to mix the first oscillator signal with the in-phase radio beat frequency so that a first lower side band signal is obtained, and
a second mixer (106b) that is configured to mix the second oscillator signal with the quadrature shifted beat frequency so that a second lower side band signal shifted in quadrature is obtained.

5. The light source of any of the preceding claims, comprising
a waveform generator (82),
a laser driver (17) connected to the loop filter (70) and the waveform generator (82), wherein the laser driver (17) is configured to produce a laser injection current that is applied to the laser gain medium (36); and
a phase shifter driver (62) that is connected to the waveform generator (82) and configured to produce a control signal that is applied to the variable phase shifter (60).

6. The light source of any of the preceding claims, comprising a further optical splitter (68) configured to split off a portion of the laser light, said portion forming a signal that is emitted by the FMCW LiDAR device.

7. The light source of claim 6, comprising an optical isolator (43) arranged in a light path downstream of the further optical splitter (68).

8. An FMCW LiDAR device for measuring a range to an external object (12), comprising the tunable light source (16) of any of the preceding claims, a detector (32) configured to detect a superposition of a portion of the laser light that was reflected at the external object (12) with a portion of the laser light that was not reflected at the external object, and a calculation unit (34) configured to determine the range to the object (12) based on the superposition detected by the detector (32).
